# EUROPÄISCHE PATENTSCHRIFT

(11) **EP 4 367 765 B1**
(45) Veröffentlichungstag und Bekanntmachung des Hinweises auf die Patenterteilung: **03.09.2025**
(21) Anmeldenummer: 22747288.3
(22) Anmeldetag: 03.07.2022
(51) Int. Cl.: H02H 3/087, H02H 3/18, H02H 3/33

(54) **FEHLERSTROMÜBERWACHUNG FÜR EIN GLEICHSPANNUNGSSCHALTGERÄT**
RESIDUAL CURRENT MONITORING FOR A DC VOLTAGE SWITCHING DEVICE
SURVEILLANCE DE COURANT DE DÉFAUT POUR UN APPAREIL DE COMMUTATION À TENSION CONTINUE

(30) Priorität: 05.07.2021 BE 202105520
(43) Veröffentlichungstag der Anmeldung: 15.05.2024
(73) Patentinhaber: PHOENIX CONTACT GMBH & CO. KG, 32825 Blomberg (DE)
(72) Erfinder: GROTE, Tobias, 32676 Lüdge (DE); HEUER, Lutz, 32825 Blomberg (DE)
(74) Vertreter: Blumbach · Zinngrebe Patentanwälte PartG mbB
(86) Internationale Anmeldenummer: PCT/EP2022/068359
(87) Internationale Veröffentlichungsnummer: WO 2023/280730

(56) Entgegenhaltungen:
- DE-B4- 102019 203 977
- US-A- 4 739 275
- US-A1- 2006 072 270
- US-A1- 2014 268 434

## Beschreibung

Die Erfindung betrifft eine Fehlerstromüberwachung für ein Gleichspannungsschaltgerät, insbesondere ein Verfahren zur Fehlerstromüberwachung beim elektrischen Koppeln einer Gleichspannungslast über einen Plusleiter und Minusleiter an eine Gleichspannungsquelle, ein Gleichspannungsschaltgerät zum Koppeln einer Gleichspannungslast über einen Plusleiter und Minusleiter an eine Gleichspannungsquelle sowie ein Schaltsystem mit wenigstens einem solchen Gleichspannungsschaltgerät.

Aus dem Stand der Technik ist es grundsätzlich bekannt, zum elektrischen Koppeln von Gleichspannungslasten an Gleichspannungsquellen Gleichspannungsschaltgeräte einzusetzen. Hierbei können sowohl ein Plusleiter und ein Minusleiter, über welche die Gleichspannungslast an die Gleichspannungsquelle gekoppelt wird, durch das Gleichspannungsschaltgerät geführt sein. Im Rahmen der Erfindung muss die Gleichspannungslast keine einzelne Last sein, sondern kann sich auch aus einer Gruppe von Gleichspannungslasten zusammensetzen oder als ein Gleichstromnetz ausgebildet sein, mit einer Vielzahl von darüber betriebenen Gleichspannungslasten. Solche Gleichspannungsschaltgeräte zum elektrischen Koppeln von Gleichspannungslasten an Gleichspannungsquellen gewinnen immer mehr an Bedeutung, insbesondere auf Fabrikebene und/oder bei der Umsetzung intelligenter Netze, da ein übergeordnetes Energiemanagementsystem für die wirtschaftliche und die energetische Optimierung des elektrisch gekoppelten Gleichstromnetzes einfach integriert werden kann und vordefinierte Strom-Spannungs-Kennlinien in den folglich enthaltenen Gleichspannungsgeräten für den sofortigen Ausgleich von Leistungsbedarf und Leistungsangebot sorgen können. Darüber hinaus können viele Komponenten, die bei Wechselstrom benötigt werden, bei Gleichstrom entfallen. Die Vorteile einer Gleichstrom-Versorgung (DC-Versorgung) für Industrie-Anlagen liegen daher auf der Hand. Im Rahmen der Erfindung kann eine an eine Gleichspannungsquelle jeweils elektrische koppelbare Gleichspannungslast folglich insbesondere auch eine logische Einheit bilden und/oder Komponenten mit starken funktionalen Abhängigkeiten zueinander besitzen und/oder Zwischenkreiskapazitäten beinhalten, um schaltfrequente Ausgleichsvorgänge zwischen einzelnen Geräten von der Gleichspannungsquelle bzw. der DC-Versorgung fern zu halten, und/oder über ein Gleichspannungsschaltgerät an die Gleichspannungsquelle bzw. die DC-Versorgung elektrisch gekoppelt sein.

Fließt hierbei in einem Gleichstromkreis ein Fehlerstrom, also insbesondere ein Strom, der aufgrund eines Isolationsfehlers über eine gegebene Fehlerstelle fließt, muss bei Erreichen eines bestimmten Schwellwertes der Gleichstromkreis in der Regel aus Sicherheitsgründen abgeschaltet werden. Ferner muss insbesondere bei Netzformen, bei denen das Erdpotential nicht von den aktiven Leitern isoliert ist (z.B. TN-Netz), bei einem Erdschluss der Fehlerort vom Rest des Netzes getrennt werden. Bei ausreichender Niederohmigkeit kann ein Erdschluss z.B. zu einem Erdschlussstrom führen, der eine vorgeschaltete Sicherung zum Ansprechen bringt. Bei einem hochohmigen Erdschluss dagegen ist der Erdschlussstrom oftmals zu gering, um die Sicherung ansprechen zu lassen. Insbesondere solche Erdströme als eine Art von Fehlerströmen sind besonders gefährlich, da sie zu Stromunfällen oder zu Anlagenbränden führen können.

Zur Fehlerstromüberwachung beim elektrischen Koppeln einer Gleichspannungslast an eine Gleichspannungsquelle sind aus dem Stand der Technik unterschiedliche Verfahren und Vorrichtungen bekannt, wobei hierzu beispielhaft auf die DE 10 2019 203 983 A1, DE 10 2019 203 977 B4, EP 3 723 220 A1, EP 3 723 224 A1, WO 2008/022404 A1 und WO 2018/172134 A1 verwiesen wird.

Aufgabe der Erfindung ist es, eine neue, insbesondere auch eine gegenüber dem Stand der Technik verbesserte Art einer Fehlerstromüberwachung beim elektrischen Koppeln einer Gleichspannungslast über einen Plusleiter und Minusleiter an eine Gleichspannungsquelle zu schaffen, welche mit einer geringen Anzahl von Komponenten auskommt.

Die Lösung gemäß Erfindung ist durch ein Verfahren, ein Gleichspannungsschaltgerät und ein Schaltsystem mit den Merkmalen gemäß anhängendem Anspruch 1, 3 bzw. 9 gegeben.

Demgemäß ist ein Verfahren zur Fehlerstromüberwachung beim elektrischen Koppeln einer Gleichspannungslast über einen Plusleiter und Minusleiter an eine Gleichspannungsquelle vorgeschlagen, bei welchem ein sich insgesamt um den Plusleiter und Minusleiter herum ausbildenden Magnetfeld erfasst und anschließend gegenüber einem Schwellwert verglichen wird, wobei bei Durchschreiten des Schwellwertes, die Gleichspannungslast abgekoppelt wird.

Insbesondere wird somit ferner ein Gleichspannungsschaltgerät zum Koppeln einer Gleichspannungslast über einen Plusleiter und Minusleiter an eine Gleichspannungsquelle vorgeschlagen, wobei die Plus- und Minusleiter durch das Gleichspannungsschaltgerät geführt sind und welches ein Schaltelement zum Ankoppeln und Abkoppeln der Gleichspannungslast, einen Sensor und eine mit dem Sensor und dem Schaltelement verbundene Auswertevorrichtung besitzt, wobei der Sensor, insbesondere ein Hall-Effekt-Sensor, zum Erfassen eines sich insgesamt um den Plusleiter und Minusleiter herum ausbildenden Magnetfeldes eingerichtet ist und Auswertevorrichtung zum Vergleichen des erfassten Magnetfeldes gegenüber einem Schwellwert sowie zum Aktivieren des Schaltelements zum Abkoppeln der Gleichspannungslast bei Durchschreiten des Schwellwertes.

Es sei darauf hingewiesen, dass das Durchschreiten des Schwellwertes im Rahmen der Erfindung zweckmäßig das Überschreiten in positiver Richtung sowie das Unterschreiten in negativer Richtung umfasst.

Ein wesentlicher Vorteil der Erfindung ist folglich darin zu sehen, dass nur ein einziger Sensor zu Erfassung eines Fehlerstroms in Bezug auf die Plus- und Minusleiter, denn gibt es keinen Fehlerstrom, insbesondere Stromfluss zum Erdpotential, dann sind die Beträge der Ströme im Plusleiter und Minusleiter im Wesentlichen gleich groß und das sich insgesamt um den Plusleiter und Minusleiter herum ausbildende Magnetfeld hat folglich im Wesentlichen den Wert Null. Ferner können hierbei über den Vergleich mit einem Schwellwert zweckmäßiger Weise auch tolerierbare Stromänderungen, -schwankungen und/oder -verluste beim Betreiben der Gleichspannungslast mitberücksichtigt werden.

Mit einem solchen Gleichspannungsschaltgerät lässt sich ferner insbesondere ein Schaltsystem umsetzen, bei welchem an einem Eingang des Gleichspannungsschaltgerätes der Plusleiter und der Minusleiter an ein gleichgerichtetes dreiphasiges AC-Netz oder an einen Gleichspannungsbus als Gleichspannungsquelle angeschlossen sind und an einem Ausgang des Gleichspannungsschaltgerätes über den Plusleiter und den Minusleiter ein Gleichspannungszweig mit der Gleichspannungslast an- und abkoppelbar ist.

Weitere zweckmäßige Ausführungsformen sind Gegenstand der anhängenden, abhängigen Ansprüche.

Die Erfindung wird nachfolgend unter Bezugnahme auf die beigefügten Zeichnungen anhand bevorzugter Ausführungsbeispiele detaillierter beschrieben, woraus sich weitere Merkmale und Vorteile der Erfindung zeigen. In den Zeichnungen zeigen:
- Fig. 1: stark vereinfacht eine bevorzugte Ausführungsform eines Gleichspannungsschaltgerätes nach der Erfindung,
- Fig. 2: stark vereinfacht einen DC-Bus mit Plus- und Minusleiter als Gleichspannungsquelle mit zwei DC-Abzweigen, die mittels Gleichspannungsschaltgeräten gemäß der Erfindung an den DC-Bus gekoppelt werden können,
- Fig. 3a: stark vereinfacht die von einem Ferritkern umschlossenen Plus- und Minusleiter mit einem in einem Luftspalt des Ferritkerns angeordneten Sensor, und
- Fig. 3b: stark vereinfacht die auf einer Leiterplatte angeordneten Plus- und Minusleiter, wobei die Leiterplatte von einem Ferritkern umschlossen und in einem Luftspalt des Ferritkerns ein Sensor angeordnet ist.

Nachfolgend wird die Erfindung unter Bezugnahme auf die beigefügten Zeichnungen anhand bevorzugter Ausführungsbeispiele detaillierter beschrieben.

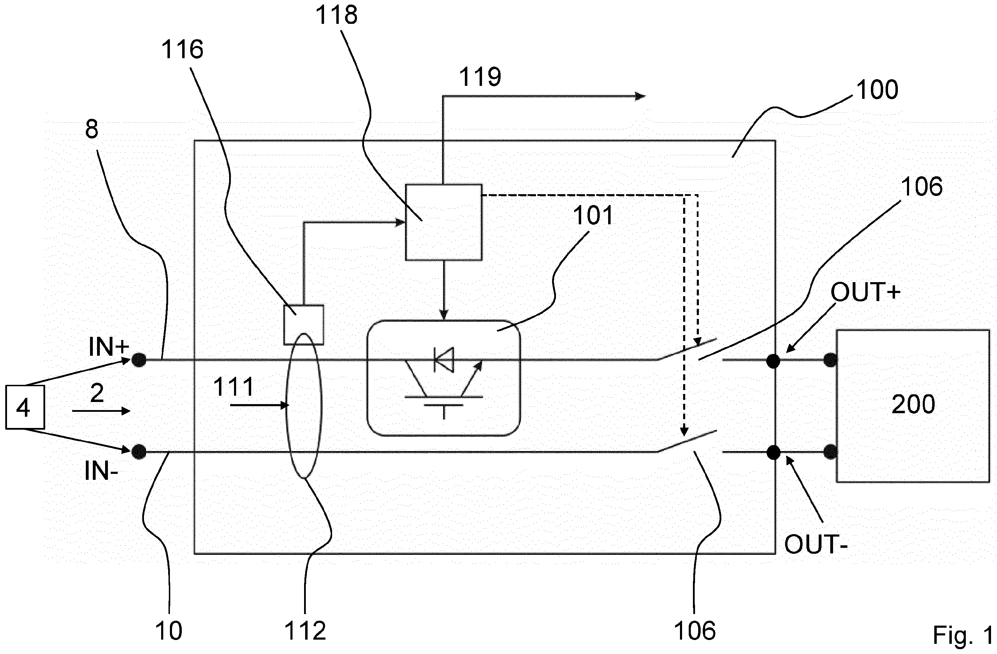

In Fig. 1 ist stark vereinfacht eine bevorzugte Ausführungsform eines Gleichspannungsschaltgerätes nach der Erfindung gezeigt, mittels welchem in zweckmäßiger Weise ein Verfahren zur Fehlerstromüberwachung beim elektrischen Koppeln einer Gleichspannungslast 200 über einen Plusleiter 8 und Minusleiter 10 an eine Gleichspannungsquelle 4 umsetzbar ist, bei welchem ein sich insgesamt um den Plusleiter und Minusleiter herum ausbildendes Magnetfeld erfasst, das erfasste Magnetfeld anschließend gegenüber einem Schwellwert verglichen werden kann und bei Durchschreiten des Schwellwertes die Gleichspannungslast 200 abgekoppelt werden kann.

Im Einzelnen ist bei Fig. 1 ein Gleichspannungsschaltgerät 100 dargestellt, welches zum Koppeln einer Gleichspannungslast 200 über einen Plusleiter 8 und einen Minusleiter 10 an eine Gleichspannungsquelle 4 eingerichtet ist. Mittels des Gleichspannungsschaltgeräts 100 wird quasi ein Gleichspannungsabzweig 2 zwischen der Gleichspannungsquelle 4 und der Gleichspannungslast 200 eingerichtet. Der Plusleiter 8 und der Minusleiter 10 sind hierbei durch das Gleichspannungsschaltgerät 100 geführt. Das Gleichspannungsschaltgerät 100 umfasst, d.h. beinhaltet ein Schaltelement, d.h. zumindest ein Schaltelement 101 zum Ankoppeln und Abkoppeln der Gleichspannungslast 200. Dieses Schaltelement 101 ist insbesondere ein halbleiterbasiertes, elektronisch steuerbares Schaltelement, welches zweckmäßig auch für das betriebliche Schalten in einem der Stromleiter, d.h. Plus- oder Minusleiter benötigt wird. In der dargestellten Ausführungsform ist dieses Schaltelement 101 zum Ankoppeln und Abkoppeln der Gleichspannungslast 200 in den Plusleiter 8 integriert. Im Fall eines halbleiterbasierten, elektronisch steuerbaren Schaltelement kann dieses alternativ auch in anti-serieller Anordnung aufgebaut sein, d.h. insbesondere als bidirektionaler Schalter, so dass ein Betrieb der Gleichspannungslast, d.h. der hierfür nötige Stromfluss mit entsprechenden Anschluss an die Gleichspannungsquelle, grundsätzlich bidirektional möglich und für die Begrenzung eines jeweiligen Stromflusses in die eine oder andere Richtung jeweils einer der antiseriell geschalteten Dioden des Halbleiterelements Sorge tragen kann. Grundsätzlich kann selbstverständlich auch ein weiteres Halbleiterschaltelement im jeweils anderen Leiter, d.h. gemäß Fig. 1 auch im Minusleiter integriert sein.

Ferner umfasst das Gleichspannungsschaltgerät 100 einen Sensor 116, der zum Erfassen eines sich insgesamt um den Plusleiter 8 und Minusleiter 10 herum ausbildenden Magnetfeldes eingerichtet ist. Eine mit dem Sensor 116 und dem Schaltelement, d.h. zweckmäßig zumindest mit dem Schaltelement 101 verbundene Auswertevorrichtung 118 des Gleichspannungsschaltgeräts 100 ist schließlich eingerichtet, das erfasste Magnetfeld, d.h. in praktischer Umsetzung das wertemäßig erfasste Magnetfeld, gegenüber einem Schwellwert zu vergleichen und das Schaltelement, d.h. insbesondere das gemäß Fig. 1 gezeigte Schaltelement 101 zum Abkoppeln der Gleichspannungslast bei Durchschreiten des Schwellwertes entsprechend zu aktivieren. Da dieses gemäß dargestellter Ausbildung ein halbleiterbasiertes Schaltelement ist, ist die Gleichspannungslast 200 in Folge zumindest elektrisch abgekoppelt und kann nicht mehr über die Gleichspannungsquelle 4 betrieben werden.

Die Fehlerstromüberwachung gemäß der Erfindung erfolgt somit durch das Erfassen eines Differenzstroms oder Summenstroms über beide Leiter, wobei hierzu wiederum das sich insgesamt um den Plusleiter 8 und Minusleiter 10 herum ausbildende Magnetfeld erfasst wird. Dabei ist unter dem Begriff "Differenz", wie er im Rahmen der vorliegenden Beschreibung und der Ansprüche verwendet wird, die betragsmäßige Differenz zu verstehen.

Zur Erfassung des Magnetfeldes kann als Sensor 116 folglich insbesondere ein Hall-Effekt-Sensor eingesetzt werden.

Gemäß einer besonders bevorzugten Ausführungsform, insbesondere für eine einfach zu realisierende Erfassung des sich insgesamt um diese Leiter herum ausbildenden Magnetfeldes sind, wie bei Fig. 1 skizziert, der Plusleiter 8 und der Minusleiter 10 durch eine gemeinsame Durchgangsöffnung 111 eines Ferritkerns 112 geführt. Der vom Gleichspannungsschaltgerät somit hierzu zweckmäßig mitumfasste Ferritkern ist ferner bevorzugt an einer Stelle aufgetrennt, bildet dort folglich einen Luftspalt 114 aus, wobei der Sensor 116 an dieser aufgetrennten Stelle, d.h. insbesondere im Luftspalt 114 angeordnet wird bzw. ist. Mit Hilfe eines solchen Ferritkerns können die magnetischen Feldlinien somit zweckmäßig gebündelt und geführt werden.

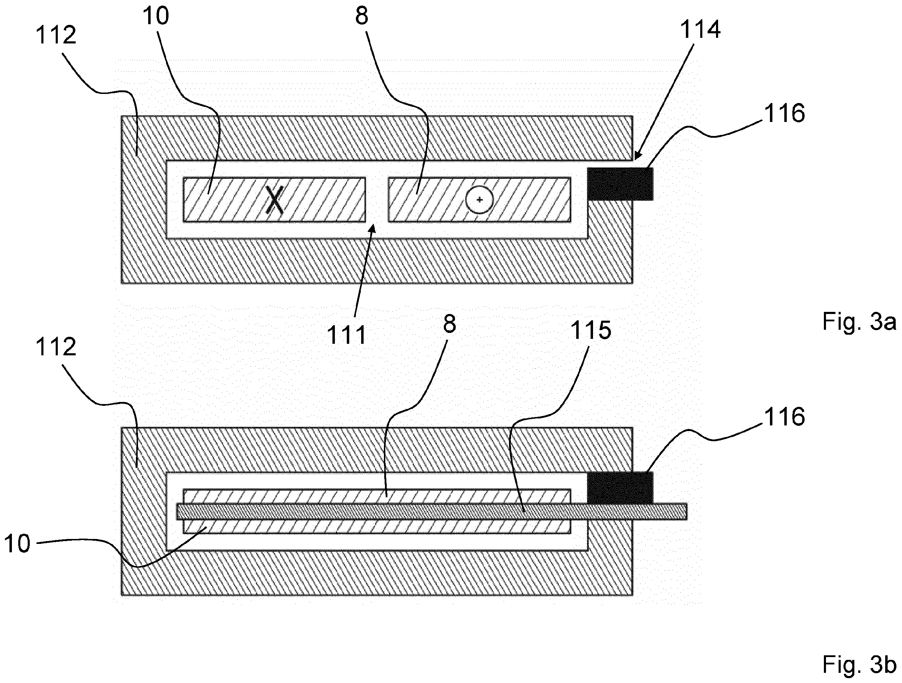

Die Fig. 3a und 3b zeigen hierzu stark vereinfacht zwei mögliche zweckmäßige Ausführungsformen, bei welchen die Plus- und Minusleiter 8, 10 von einem Ferritkern 112 umschlossen sind und der Sensor 116 in einem Luftspalt 114 des Ferritkerns angeordnet ist. Bei der Fig. 3b sind die Plus- und Minusleiter 8, 10 hierbei auf einer Leiterplatte 115 angeordneten, d.h. insbesondere als Leiterbahnen ausgebildet, und die Leiterplatte 115 ist durch die Durchgangsöffnung 111 des Ferritkerns 112 geführt bzw. von dem Ferritkern 112 umschlossen. Auch kann der Sensor 116 bei Verwendung einer Leiterplatte 115 gleichermaßen auf dieser platziert sein, und zwar zweckmäßig so, dass dieser wiederum im Luftspalt angeordnet ist. Gemäß Fig. 3b kann der Luftspalt auch durch den Sensor oder wie dargestellt, auch durch die Leiterplatte 115 und dem hierauf platzierten Sensor vollständig ausgefüllt sein.

Gibt es keinen Fehlerstrom, d.h. insbesondere keinen Stromfluss zum Erdpotential im Gleichspannungsabzweig, dann sind die Beträge der Ströme im Plusleiter und Minusleiter im optimalen Fall gleich groß, d.h. Summe der Ströme ist gleich Null bzw. die betragsmäßige Differenz ist gleich Null. Folglich ist der Sensor 116 bevorzugt angeordnet, bei betragsmäßig gleichem elektrischen Strom im Plusleiter 8 und Minusleiter 10 kein Magnetfeld zu erfassen, beziehungsweise ein Magnetfeld mit dem Wert Null zu erfassen. Gibt es einen Fehlerstrom im Gleichspannungsabzweig, dann sind die Beträge der Ströme im Plusleiter 8 und Minusleiter 10 nicht mehr gleich groß und es kann folglich ein Magnetfeld ungleich Null erfasst werden. Das erfasste Magnetfeld kann somit ferner je nach Beträge der Ströme im Plusleiter 8 und Minusleiter 10 und in Abhängigkeit der jeweiligen Stromrichtung folglich auch einen Wert größer oder auch kleiner Null annehmen. In Folge der erfindungsgemäßen Erfassung des Stromflusses insgesamt mittels Erfassung eines sich insgesamt um die Plus- und Minusleiter herum ausbildendenden Magnetfeldes ist somit jedoch der Einsatz von nur einem einzigen Sensor für die Erkennung eines Fehlerstroms im Gleichspannungsabzweig 2 einschl. der daran elektrisch angeschalteten Gleichspannungslast 200 notwendig.

Die Auswertevorrichtung 118 kann zur Auswertung des erfassten Magnetfeldes, d.h. insbesondere zum Vergleichen des erfassten Magnetfeldes gegenüber einem Schwellwert und zum Aktivieren des zumindest einen Schaltelements 101 eine analoge Schaltung, eine diskrete Schaltung oder bevorzugt auch einen µC (Mikrocontroller) besitzen. Überschreitet oder Unterschreitet je nach Ausführung und/oder Anwendungsgebiet der Differenz- bzw. Summenstrom einen insbesondere vorher festgelegten Schwellenwert, so wird das Schaltelement, d.h. insbesondere das gemäß Fig. 1 gezeigte Schaltelement 101 zum Abkoppeln der Last 200 von der Quelle 4 entsprechend aktiviert, d.h. insbesondere abgeschaltet. Das Schaltelement zum Ankoppeln und Abkoppeln der Gleichspannungslast 200 kann ergänzend oder alternativ jedoch auch ein zweites und ein drittes Schaltelement 106 umfassen, insbesondere ein zweites und drittes elektromechanisches Schaltelement, wobei eines von dem zweiten und dritten Schaltelement 106 in den Plusleiter 8 und das andere in den Minusleiter 10 integriert ist. Hierdurch kann, insbesondere gleichermaßen mittels der Auswertevorrichtung 118 auch eine galvanische Entkopplung der Last 200 von der Quelle 4 bewirkt werden. Hierzu kann das zweite und dritte Schaltelement 106 folglich Relaiskontakte besitzen. Gemäß bevorzugter Ausbildung ist jedoch zumindest ein insbesondere als halbleiterbasiertes, elektronisch steuerbares Schaltelement eingerichtetes erstes Schaltelement 101 in den Plusleiter 8 oder in den Minusleiter 10 integriert.

Durchschreitet folglich der Wert des um beide Leiter insgesamt herum erfassten Magnetfeldes, und also insbesondere Differenzstrom bzw. Summenstrom beider Leiter, beispielsweise einen vorher festgelegten kritischen Wert, so kann je nach durchschrittenen Wert und spezieller Ausbildung das erste Schaltelement 101 und/oder das zweite sowie dritte Schaltelement 106 durch die Auswertungsvorrichtung 118 abgeschaltet und damit der Gleichspannungsabzweig elektrisch bzw. galvanisch von der Gleichspannungsquelle 4 entkoppelt. Ferner wird durch das Abschalten des zweiten sowie dritten Schaltelements 106 der Stromfluss in beide Richtungen verhindert, wohingegen beim Abschalten des wie bei Fig. 1 dargestellten ersten Schaltelements 101 der Stromfluss zunächst nur in einem der Leiter unterbunden wird, sofern nicht auch im jeweils anderen Leiter, d.h. gemäß Fig. 1 auch im Minusleiter, ein weiteres Halbleiterschaltelement integriert ist. Durch das zweite sowie dritte Schaltelement 106 erfolgt somit eine sichere Trennung des DC-Ausgangs vom DC-Eingang.

Die Auswertevorrichtung 118 besitzt hierbei ferner in zweckmäßiger Weiterbildung einen Meldeausgang oder eine Kommunikationsschnittstelle, und zwar zum Ausgeben 119 eines Meldesignals, wenn der Schwellwert durchschritten wird und/oder wenn der Schwellwert zwar nicht durchschritten wird, aber das erfasste Magnetfeld einen betragsmäßig größeren Wert aufweist als ein gegenüber dem Schwellwert betragsmäßig kleinerer zweiter Schwellwert. Somit können über den Vergleich mit einem Schwellwert in äußerst zweckmäßiger Weise z.B. auch tolerierbare Stromänderungen, schwankungen und/oder -verluste beim Betreiben der Gleichspannungslast auf vielfältige und flexible Art und Weise mitberücksichtigt werden.

Zweckmäßig ist die Auswertungsvorrichtung 118 ferner nicht nur ausgebildet und eingerichtet, das Entkoppeln der Gleichspannungslast 200 bzw. den ganzen Gleichspannungsabzweig 2 elektrisch und/oder galvanisch von der Gleichspannungsquelle 4 mittels entsprechenden Aktivierungsbefehlen an das Schaltelement oder die Schaltelemente, d.h. zu dessen bzw. deren Ausschalten, zu bewirken sondern auch das elektrisch und/oder galvanische Ankoppeln der Gleichspannungslast 200 bzw. des ganzen Gleichspannungsabzweiges 2 an die Gleichspannungsquelle 4 mittels entsprechenden Aktivierungsbefehlen an das Schaltelement oder die Schaltelemente, d.h. zu dessen bzw. deren Einschalten, zu bewirken. Insbesondere ein Befehl an die Auswertungsvorrichtung 118 zum hierauf basierten Bewirken des Einschaltens kann gemäß zweckmäßiger Ausführung von der Auswertungsvorrichtung 118 beispielsweise auch über eine wie vorbeschriebene Kommunikationsschnittstelle oder über eine andere Eingangsschnittstelle, insbesondere einen digitalen Eingang, entgegengenommen werden.

Mit einem wie vorstehend in diversen Ausführungsvarianten beschriebenen Gleichspannungsschaltgerät lässt sich folglich ferner insbesondere ein Schaltsystem umsetzen, bei welchem an einem Eingang IN+, IN- des Gleichspannungsschaltgerätes 100 der Plusleiter 8 und der Minusleiter 10 an die Gleichspannungsquelle 4, z.B. auch an einen Gleichspannungsbus als Gleichspannungsquelle 4, angeschlossen sind und an einem Ausgang OUT+ , OUT- des Gleichspannungsschaltgerätes 100 über den Plusleiter 8 und den Minusleiter 10 ein Gleichspannungszweig mit der Gleichspannungslast 200 an- und abkoppelbar ist (vgl. Fig. 1).

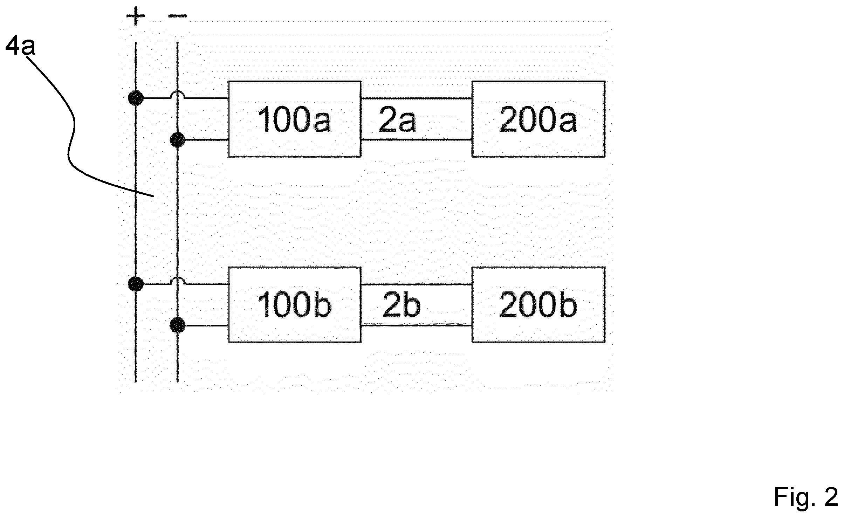

In Fig. 2 ist hierauf basierend stark vereinfacht ein bevorzugtes Schaltsystem skizziert, welches ein erstes solches Gleichspannungsschaltgerät 100a einen Eingang und einen Ausgang besitzt, wobei der Plusleiter und der Minusleiter 10 Eingang an einen Gleichspannungsbus 4a als Gleichspannungsquelle angeschlossen sind und am Ausgang über den Plusleiter und den Minusleiter ein Gleichspannungszweig 2a mit einer Gleichspannungslast 200a an- und abkoppelbar ist.

In zweckmäßiger Weiterbildung ist gemäß Fig. 2 ferner zumindest ein weiteres solches Gleichspannungsschaltgerät 100b mit einem Eingang und einen Ausgang umfasst, wobei auch bei diesem weiteren Gleichspannungsschaltgerät 100b der Plusleiter 8 und der Minusleiter 10 gleichermaßen am Eingang an den Gleichspannungsbus 4a angeschlossen sind und am Ausgang über den Plusleiter 8 und den Minusleiter 10 ein weiterer Gleichspannungszweig 2b mit einer Gleichspannungslast 200b an- und abkoppelbar ist.

Unter Würdigung vorstehender Beschreibung kann muss die Gleichspannungslast keine einzelne Last sein, sondern kann sich aus einer Gruppe von Gleichspannungslasten zusammensetzen oder als ein Gleichstromnetz ausgebildet sein, mit einer Vielzahl von darüber betriebenen Gleichspannungslasten.

Zum schnellen Entkoppeln der Gleichspannungslast oder des Gleichspannungsabzweigs von der Gleichspannungsquelle, insbesondere einem Gleichspannungsbus eignet sich in praktischer Umsetzung für das halbleiterbasierte, elektronisch steuerbare Schaltelement 101 z.B. ein MOSFET ("metal-oxide-semiconductor field-effect transistor") oder IGBT ("Insulated Gate Bipolar Transistor").

Mittels der vorbeschriebenen Auswertevorrichtung 118 lässt sich folglich anwendungsspezifisch und/oder je nach spezifischer Ausführung insbesondere
- eine Ladestrombegrenzung angeschlossener Gleichspannungslasten realisieren, d.h. ein Vorladen von Zwischenkreiskondensatoren der angeschlossenen Lasten auf das Eingangsspannungsniveau,
- eine Überwachung verschiedener Zustandsgrößen, wie z.B. der Eingangsspannung, der Ausgangsspannung, des Laststroms, und von Ableitströmen gegen PE (Fehlerstrom),
- ein Abschalten im Fehlerfall, d.h. sobald eine Zustandsgröße den zulässigen Bereich verlässt.
- eine Fehlerstromabschaltung, d.h. ein Abschalten, wenn die Differenz der Ströme in Plus- und Minusleiter zu groß wird, und/oder
- eine schnelle Abschaltung bei einem Kurzschluss auf der Ausgangsseite.

### Bezugszeichenliste

- 2, 2a, 2b: Gleichspannungszweig
- 4: Gleichspannungsquelle
- 4a: Gleichspannungsbus
- 8: Positivleiter
- 10: Negativleiter
- 100, 100a, 100b: Gleichspannungsschaltgerät
- 101: erstes Schaltelement
- 106: zweites, drittes Schaltelement
- 111: Durchgangsöffnung
- 112: Magnetkern
- 114: Luftspalt
- 115: PCB
- 116: Sensor
- 118: Auswertevorrichtung
- 119: Ausgabe von Meldeausgang oder Kommunikationsschnittstelle
- 200, 200a, 200b: Gleichspannungslast

## Patentansprüche

1. Verfahren zur Fehlerstromüberwachung beim elektrischen Koppeln einer Gleichspannungslast (200) über einen Plusleiter (8) und Minusleiter (10) an eine Gleichspannungsquelle (4), mit folgenden Schritten:
Erfassen eines sich insgesamt um den Plusleiter (8) und Minusleiter (10) herum ausbildenden Magnetfeldes zum Erfassen eines betragsmäßigen Differenzstroms über Plusleiter (8) und Minusleiter (10), wobei ein Magnetfeld mit im Wesentlichen dem Wert Null erfasst wird, wenn es keinen Fehlerstrom gibt, und ein Magnetfeld ungleich Null erfasst wird, wenn es einen Fehlerstrom gibt,
Vergleichen (118) des erfassten Magnetfeldes gegenüber einem Schwellwert,
und sobald der zu überwachende Fehlerstrom einen zulässigen Bereich derart verlässt, dass der betragsmäßige Differenzstrom in Plusleiter (8) und Minusleiter (10) einen vorher festgelegten Wert durchschreitet und entsprechend das erfasste Magnetfeld den Schwellwert durchschreitet, Aktivieren eines Schaltelements (101, 106) zum Abkoppeln der Gleichspannungslast (200).

2. Verfahren nach Anspruch 1, wobei der Plusleiter und Minusleiter durch eine gemeinsame Durchgangsöffnung (111) eines an einer Stelle aufgetrennten und dort mit einem Sensor (116) versehenen Ferritkerns (112) geführt werden.

3. Verfahren nach Anspruch 2, wobei als der Sensor (116) ein Hall-Effekt-Sensor verwendet wird.

4. Gleichspannungsschaltgerät (100, 100a) zum Koppeln einer Gleichspannungslast (200) über einen Plusleiter (8) und Minusleiter (10) an eine Gleichspannungsquelle (4), wobei der Plusleiter (8) und der Minusleiter (10) durch das Gleichspannungsschaltgerät (100, 100a) geführt sind, umfassend:
- ein Schaltelement (101, 106) zum Ankoppeln und Abkoppeln der Gleichspannungslast (200, 200a);
- einen Sensor (116), eingerichtet zum Erfassen eines sich insgesamt um den Plusleiter (8) und Minusleiter (10) herum ausbildenden Magnetfeldes zum Erfassen eines betragsmäßigen Differenzstroms über Plusleiter (8) und Minusleiter (10), wobei das Magnetfeld im Wesentlichen den Wert Null aufweist, wenn es keinen Fehlerstrom gibt, und das Magnetfeld ungleich Null ist, wenn es einen Fehlerstrom gibt; und
- eine mit dem Sensor (116) und dem Schaltelement (101, 106) verbundene Auswertevorrichtung (118), die eingerichtet ist zum Vergleichen des erfassten Magnetfeldes gegenüber einem Schwellwert und zum Aktivieren des Schaltelements (101, 106) zum Abkoppeln der Gleichspannungslast (200), sobald der Fehlerstrom einen zulässigen Bereich derart verlässt, dass der betragsmäßige Differenzstrom in Plusleiter (8) und Minusleiter (10) einen vorher festgelegten Wert durchschreitet und entsprechend das erfasste Magnetfeld den Schwellwert durchschreitet.

5. Gleichspannungsschaltgerät (100, 100a) nach Anspruch 4, wobei der Sensor (116) ein Hall-Effekt-Sensor ist.

6. Gleichspannungsschaltgerät (100, 100a) nach Anspruch 4 oder 5,
wobei der Sensor (116) angeordnet ist, bei betragsmäßig gleichem elektrischen Strom im Plusleiter (8) und Minusleiter (10) kein Magnetfeld zu erfassen, und/oder,
wobei das Gleichspannungsschaltgerät (100, 100a) ferner einen, eine Durchgangsöffnung (111) aufweisenden Ferritkern (112) umfasst, der an einer Stelle zur Bildung eines Luftspaltes (14) aufgetrennt ist, wobei der Plusleiter (8) und der Minusleiter (10) durch die Durchgangsöffnung (111) geführt sind und der Sensor (116) im Luftspalt (14) angeordnet ist.

7. Gleichspannungsschaltgerät (100, 100a) nach einem der Ansprüche 4 bis 6, wobei das Schaltelement zum Ankoppeln und Abkoppeln der Gleichspannungslast ((200, 200a) ein erstes, in den Plusleiter (8) oder in den Minusleiter (10) integriertes Schaltelement (101) umfasst.

8. Gleichspannungsschaltgerät (100, 100a) nach Anspruch 7, wobei das erste Schaltelement (101) ein halbleiterbasiertes, elektronisch steuerbares Schaltelement ist.

9. Gleichspannungsschaltgerät (100, 100a) nach einem der Ansprüche 4 bis 8, wobei das Schaltelement zum Ankoppeln und Abkoppeln der Gleichspannungslast (200) ein zweites und ein drittes Schaltelement (106) umfasst, wobei eines von dem zweiten und dritten Schaltelement (106) in den Plusleiter (8) und das andere in den Minusleiter (10) integriert ist.

10. Gleichspannungsschaltgerät (100, 100a) nach Anspruch 9, wobei das zweite und das dritte Schaltelement (106) jeweils ein elektromechanisches Schaltelement ist.

11. Gleichspannungsschaltgerät (100, 100a) nach einem der Ansprüche 4 bis 10, wobei der Plusleiter (8) und der Minusleiter (10) als Leiterbahnen auf einer Platine ausgeführt sind.

12. Gleichspannungsschaltgerät (100, 100a) nach einem der Ansprüche 4 bis 11, wobei die Auswertevorrichtung (118) einen Meldeausgang oder eine Kommunikationsschnittstelle besitzt, zum Ausgeben (119) eines Meldesignals, wenn der Schwellwert durchschritten wird und/oder wenn der Schwellwert zwar nicht durchschritten wird, aber das erfasste Magnetfeld einen betragsmäßig größeren Wert aufweist als ein gegenüber dem Schwellwert betragsmäßig kleinerer zweiter Schwellwert.

13. Schaltsystem mit einem Gleichspannungsschaltgerät (100, 100a) nach einem der der Ansprüche 4 bis 12, wobei das Gleichspannungsschaltgerät (100, 100a) einen Eingang und einen Ausgang besitzt, wobei der Plusleiter (8) und der Minusleiter (10) am Eingang an einen Gleichspannungsbus (4a) als Gleichspannungsquelle (4) angeschlossen ist und am Ausgang über den Plusleiter (8) und den Minusleiter (10) ein Gleichspannungszweig (2a) mit der Gleichspannungslast (200, 200a) an- und abkoppelbar ist.

## Claims

1. Method for fault current monitoring when electrically coupling a DC voltage load (200) via a positive conductor (8) and negative conductor (10) to a DC voltage source (4), having the following steps:
detecting a magnetic field which is formed overall around the positive conductor (8) and negative conductor (10) for detecting a differential current across positive (8) and negative (10) conductors and in terms of amount, wherein a magnetic field of substantially zero value is detected when there is no fault current and a non-zero magnetic field is detected when there is a fault current,
comparing (118) the detected magnetic field with respect to a threshold value,
and as soon as the fault current to be monitored leaves a permissible range in such a way that the differential current in terms of amount in positive conductor (8) and negative conductor (10) passes a predetermined value and the detected magnetic field accordingly passes the threshold value, a switching element (101, 106) is activated for disconnecting the DC voltage load (200).

2. Method according to claim 1, wherein the positive conductor and negative conductor are guided through a common through-opening (111) of a ferrite core (112) which is separated at one point and provided there with a sensor (116).

3. Method according to claim 2, wherein a Hall effect sensor is used as the sensor (116).

4. DC voltage switching device (100, 100a) for coupling a DC voltage load (200) via a positive conductor (8) and negative conductor (10) to a DC voltage source (4), the positive conductor (8) and the negative conductor (10) being routed through the DC voltage switching device (100, 100a), comprising
- a switching element (101, 106) for coupling and decoupling the DC voltage load (200, 200a);
- a sensor (116) set up for detecting a magnetic field which forms overall around the positive conductor (8) and negative conductor (10) for detecting a differential current across positive (8) and negative (10) conductors and in terms of amount, wherein the magnetic field having the value of substantially being zero when there is no fault current and the magnetic field being of non-zero when there is a fault current; and
- an evaluation device (118) connected to the sensor (116) and the switching element (101, 106), which is set up to compare the detected magnetic field with a threshold value and to activate the switching element (101, 106) to disconnect the DC voltage load as soon as the fault current leaves a permissible range in such a way that the differential current in terms of amount in positive conductor (8) and negative conductor (10) passes a predetermined value and the detected magnetic field accordingly passes the threshold value.

5. DC voltage switching device (100, 100a) according to claim 4, wherein the sensor (116) is a Hall effect sensor.

6. DC voltage switching device (100, 100a) according to claim 4 or 5,
wherein the sensor (116) is arranged not to detect a magnetic field when the electric current in the positive conductor (8) and negative conductor (10) is equal in amount,
and/or
wherein the DC voltage switching device (100, 100a) further comprises a ferrite core (112) which has a through-opening (111) and is separated at one point to form an air gap (14), the positive conductor (8) and the negative conductor (10) being guided through the through-opening (111) and the sensor (116) being arranged in the air gap (14).

7. DC voltage switching device (100, 100a) according to one of claims 4 to 6, wherein the switching element for coupling and decoupling the DC voltage load (200, 200a) comprises a first switching element (101) integrated in the positive conductor (8) or in the negative conductor (10.

8. DC voltage switching device (100, 100a) according to claim 7, wherein the first switching element (101) is a semiconductor-based, electronically controllable switching element.

9. DC voltage switching device (100, 100a) according to any one of claims 4 to 8, wherein the switching element for coupling and decoupling the DC voltage load (200) comprises a second and a third switching element (106), wherein one of the second and third switching element (106) is integrated in the positive conductor (8) and the other is integrated in the negative conductor (10).

10. DC voltage switching device (100, 100a) according to claim 9, wherein the second and third switching element (106) comprises an electromechanical switching element, respectively.

11. DC voltage switching device (100, 100a) according to one of claims 4 to 10, wherein the positive conductor (8) and the negative conductor (10) are designed as conductor tracks on a circuit board.

12. DC voltage switching device (100, 100a) according to one of claims 4 to 11, wherein the evaluation device (118) has a message output or a communication interface for outputting (119) a message signal if the threshold value is passed and/or if the threshold value is not passed but the detected magnetic field has a value which is greater in amount than a second threshold value which is smaller in amount than the threshold value.

13. Switching system with a DC voltage switching device (100, 100a) according to one of the claims 4 to 12, wherein the DC voltage switching device (100, 100a) has an input and an output, wherein the positive conductor (8) and the negative conductor (10) are connected at the input to a DC voltage bus (4a) as a DC voltage source (4) and a DC voltage branch (2a) can be connected to and disconnected from the DC voltage load (200, 200a) at the output via the positive conductor (8) and the negative conductor (10).

## Revendications

1. Procédé de surveillance du courant de fuite lors d'un couplage électrique d'une charge de tension continue (200) par l'intermédiaire d'un conducteur positif (8) et d'un conducteur négatif (10) à une source de tension continue (4), comprenant les étapes suivantes :
la détection d'un champ magnétique se formant tout autour du conducteur positif (8) et du conducteur négatif (10) pour détecter un courant différentiel en valeur par l'intermédiaire du conducteur positif (8) et du conducteur négatif (10), dans lequel un champ magnétique présentant une valeur sensiblement nulle est détecté lorsqu'il n'y a pas de courant de fuite et qu'un champ magnétique non nul est détecté lorsqu'il y a un courant de fuite,
la comparaison (118) du champ magnétique détecté à une valeur seuil, et lorsque le courant de fuite à surveiller quitte une plage admissible de telle sorte que le courant différentiel en valeur dans le conducteur positif (8) et dans le conducteur négatif (10) est supérieur à une valeur définie au préalable et l'activation, lorsque, de manière correspondante, le champ magnétique détecté est supérieur à la valeur seuil, d'un élément de commutation (101, 106) pour découpler la charge de tension continue (200).

2. Procédé selon la revendication 1, dans lequel le conducteur positif et le conducteur négatif sont guidés à travers une ouverture traversante (111) commune d'un noyau de ferrite (112) séparé en un emplacement et doté audit emplacement d'un capteur (116).

3. Procédé selon la revendication 2, dans lequel un capteur à effet Hall est utilisé en tant que capteur (116).

4. Appareil de commutation à tension continue (100, 100a) permettant de coupler une charge de tension continue (200), par l'intermédiaire d'un conducteur positif (8) et d'un conducteur négatif (10), à une source de tension continue (4), dans lequel le conducteur positif (8) et le conducteur négatif (10) sont guidés à travers l'appareil de commutation à tension continue (100, 100a), comprenant :
- un élément de commutation (101, 106) pour coupler et découpler la charge de tension continue (200, 200a) ;
- un capteur (116) conçu pour détecter un champ magnétique se formant tout autour du conducteur positif (8) et du conducteur négatif (10) pour détecter un courant différentiel en valeur par l'intermédiaire du conducteur positif (8) et du conducteur négatif (10), dans lequel un champ magnétique présente sensiblement une valeur nulle lorsqu'il n'y a pas de courant de fuite et le champ magnétique est non nul lorsqu'il y a un courant de fuite ; et
- un dispositif d'évaluation (118) relié au capteur (116) et à l'élément de commutation (101, 106), lequel est conçu pour comparer le champ magnétique détecté à une valeur seuil et pour activer l'élément de commutation (101, 106) pour découpler la charge de tension continue (200) lorsque le courant de fuite quitte une plage admissible de telle sorte que le courant différentiel en valeur dans le conducteur positif (8) et le conducteur négatif (10) est supérieur à une valeur définie au préalable et lorsque, de manière correspondante, le champ magnétique détecté est supérieur à la valeur seuil.

5. Appareil de commutation à tension continue (100, 100a) selon la revendication 4, dans lequel le capteur (116) est un capteur à effet Hall.

6. Appareil de commutation à tension continue (100, 100a) selon la revendication 4 ou 5,
dans lequel le capteur (116) est conçu, en cas de courant électrique égal en valeur dans le conducteur positif (8) et le conducteur négatif (10), pour ne pas détecter de champ magnétique,
et/ou
dans lequel l'appareil de commutation à tension continue (100, 100a) comprend en outre un noyau de ferrite (112) comportant une ouverture traversante (111), lequel est séparé en un emplacement pour former un entrefer (14), dans lequel le conducteur positif (8) et le conducteur négatif (10) sont guidés à travers l'ouverture traversante (111) et le capteur (116) est disposé dans l'entrefer (14).

7. Appareil de commutation à tension continue (100, 100a) selon l'une quelconque des revendications 4 à 6, dans lequel l'élément de commutation pour coupler et découpler la charge de tension continue (200, 200a) comprend un premier élément de commutation (101) intégré au conducteur positif (8) ou au conducteur négatif (10).

8. Appareil de commutation à tension continue (100, 100a) selon la revendication 7, dans lequel le premier élément de commutation (101) est un élément de commutation à semiconducteur, à commande électronique.

9. Appareil de commutation à tension continue (100, 100a) selon l'une quelconque des revendications 4 à 8, dans lequel l'élément de commutation pour coupler et découpler la charge de tension continue (200) comprend un deuxième et un troisième élément de commutation (106), dans lequel le deuxième et le troisième élément de commutation (106) est intégré au conducteur positif (8) et l'autre au conducteur négatif (10).

10. Appareil de commutation à tension continue (100, 100a) selon la revendication 9, dans lequel le deuxième et le troisième élément de commutation (106) sont respectivement un élément de commutation électromécanique.

11. Appareil de commutation à tension continue (100, 100a) selon l'une quelconque des revendications 4 à 10, dans lequel le conducteur positif (8) et le conducteur négatif (10) sont conçus sous la forme de pistes conductrices sur une platine.

12. Appareil de commutation à tension continue (100, 100a) selon l'une quelconque des revendications 4 à 11, dans lequel le dispositif d'évaluation (118) comporte une sortie de signalisation ou une interface de communication pour émettre (119) un signal de signalisation lorsque la valeur seuil est franchie et/ou lorsque la valeur seuil n'est certes pas franchie, mais que le champ magnétique détecté présente une valeur supérieure en valeur à une seconde valeur seuil inférieure en valeur à la valeur seuil.

13. Système de commutation comprenant un appareil de commutation à tension continue (100, 100a) selon l'une quelconque des revendications 4 à 12, dans lequel l'appareil de commutation à tension continue (100, 100a) comporte une entrée et une sortie, dans lequel le conducteur positif (8) et le conducteur négatif (10) sont connectés à l'entrée à un bus de tension continue (4a) en tant que source de tension continue (4) et un branchement de tension continue (2a) peut être couplé et découplé à la sortie, par l'intermédiaire du conducteur positif (8) et du conducteur négatif (10), à ou de la charge de tension continue (200, 200a).
